# EUROPEAN PATENT APPLICATION

(11) **EP 4 661 069 A1**
(43) Date of publication of application: **10.12.2025**
(21) Application number: 24180682.7
(22) Date of filing: 07.06.2024
(51) Int. Cl.: H01L 21/822, H01L 21/8238, H01L 27/06, H01L 27/092, H01L 29/06, H01L 29/775

(54) **CFET STRUCTURE AND METHOD OF FABRICATING A CFET STRUCTURE**

(71) Applicant: Imec VZW, 3001 Leuven (BE)
(72) Inventor: Mirabelli, Gioele, 3000 Leuven (BE); Hiblot, Gaspard, deceased (BE); Boemmels, Juergen, 3001 Heverlee (BE)
(74) Representative: Roth, Sebastian

(57) **Abstract**

The disclosure relates to a complementary field effect transistor, CFET, structure (1) which comprises at least one CFET element (10) comprising a first transistor structure (21), and a second transistor structure (22) which is arranged above the first transistor structure (21). The CFET structure (1) further comprises: a first power rail (13) arranged below the CFET element (10), wherein the first power rail (13) is electrically connected to the first transistor structure (21) from below; a side power rail (17) arranged on one side of the CFET element (10), wherein the side power rail (17) is electrically connected to the second transistor structure (22) from the side; a second power rail (14) arranged below the CFET element (10); and at least one contact structure (18) which is arranged to electrically connect the second power rail (14) with the side power rail (17).

## Description

### TECHNICAL FIELD

The present disclosure refers to a complementary field effect transistor (CFET) structure and to a method of fabricating such a CFET structure.

### BACKGROUND

In a CFET device, different transistors, particularly NMOS and PMOS transistors, maybe stacked on top of each other compared, for example, to a nanosheet device, which comprises NMOS and PMOS transistors arranged side by side with a spacing in-between them. The stacking of the transistors in the CFET device enables increasing effective channel width.

An issue in many conventional CFET devices is related to the power supply to the stacked transistors. Depending on the configuration, a bottom transistor is supplied by a VDD voltage while a top transistor (above the bottom structure) is supplied by a VSS voltage, or vice versa. The VSS and VDD voltages are typically provided by power rails which are arranged below the bottom transistor. However, it is difficult to route the power supply from such a power rail to the top transistor, as the top transistor is not directly accessible from the bottom.

A possible solution for supplying the top transistors are so-called side rails which are arranged to one side of the stacked transistors and which connect the top transistor to power. A side rail should thereby maintain two important aspects: a certain width in order to avoid power/performance degradation due to high resistance, and a certain height to connect to one of the power rails below the bottom transistor.

However, the width of the side rail is often limited by a gate-cut of the CFET architecture to avoid shorts between the VSS and the gates. At the same time, the side rail can have a tapered shape, e.g. as a result of its processing, which leads to additional restrictions in its height and width. For instance, the narrower the top width of the side rail, the more it is restricted in its maximum height due to the tapered shape which results in a narrow bottom width of the side rail. This tradeoff between width and height of the side rail puts strong limitations on the scalability of CFET devices with such side rails.

### SUMMARY

Thus, it is an objective to provide an improved CFET structure and an improved method of fabricating a CFET structure. In particular, the above-mentioned disadvantages should be avoided.

The objective is achieved by the embodiments provided in the enclosed independent claims. Advantageous implementations of the embodiments of the disclosure are further defined in the dependent claims.

A first aspect of this disclosure provides a complementary field effect transistor (CFET) structure. The CFET structure comprises at least one CFET element comprising: a first transistor structure, and a second transistor structure which is arranged above the first transistor structure. The CFET structure further comprise: a first power rail arranged below the CFET element, wherein the first power rail is electrically connected to the first transistor structure from below; a side power rail arranged on one side of the CFET element, wherein the side power rail is electrically connected to the second transistor structure from the side; a second power rail arranged below the CFET element; and at least one contact structure which is arranged to electrically connect the second power rail with the side power rail.

This achieves the advantage that an efficient connection of the side power rail to the (second) backside power rail is provided. By connecting the side power rail to the second power rail via one or more additional contact structures (e.g., a number of vias), the height of the side rail can be reduced, while the side rail is still in contact with the second power rail below.

The first transistor structure can be a respective bottom transistor structure and the second transistor structure can be a respective top transistor structure. For example, the first (or bottom) transistor structure is arranged in a first tier (or level) and the second (or top) transistor structure is arranged in a second tier (or level) of the CFET structure, wherein the second tier is arranged above the first tier. This may result in stacked transistor structures of the CFET structure, whereby the second transistor structure is stacked on the first transistor structure. The first and second transistor structures can further comprise respective channel layers as well as gate structures and source and/or drain (S/D) structures alternatively arranged along the channel layers.

The CFET element (or more specifically their transistor structures) can form a CFET cell. The CFET cell can be a base cell, in particular a double row base cell, of the CFET structure. For instance, a base cell of a CFET standard cell can comprise two rows.

The CFET cell can form a logic cell or a unit cell of the CFET structure (e.g., an inverter or NAND cell). The CFET structure may comprise a plurality of CFET cells.

The CFET element respectively the CFET cell may comprise further transistor structures or other elements, which could respectively be directly above or beneath the first and second transistor structure.

The CFET structure can be a CFET device or a part or component thereof. The CFET device can comprise a plurality of CFET cells.

Notably, in this disclosure the terms "below" and "above", "bottom" and "top", "front(side)" and "back(side)", or similar terms are to be interpreted relative to each other. In particular, these terms describe opposite sides of the CFET structure, or opposite sides of any element of the CFET structure. The terms may describe a relationship of elements (e.g., transistor structures, signal routing lines, power rails, etc.) of the CFET structure along the direction of stacking of the tiers (or levels) of the CFET structure. The stacking direction may thus align with the arrangement of the two tiers (or even more than two tiers) of the CFET structure. That is, the two or more tiers (or levels), which are arranged above each other, are arranged one after the other along a certain direction (the stacking direction).

A transistor structure in this disclosure may be or may comprise a transistor, for example a field effect transistor (FET), or may be or may comprise a more complex semiconductor-based structure, which functions like a transistor.

The transistor structures of the CFET structure may be NMOS and PMOS transistor structures. For instance, the first transistor structure may be an NMOS transistor structure and the second transistor structure may be a PMOS transistor structure, or vice versa.

The first power rail may provide a VDD voltage and the second power rail may provide a VSS voltage, or vice versa (depending on which transistor structure is NMOS and PMOS).

The side power rail (in this disclosure also referred to as: side rail) can be tapered towards the at least one contact structure. The tapering is typically due to an oxide etching step during fabrication of the side power rail. The tapering angle can be ca. 87°. This tapering can put a limit on a maximum height of the side power rail. In particular, the narrower the side power rail is at its widest section, the more restricted it is in height. This height/width limitation can be mitigated by the contact structure which allows reducing the overall height of the side power rail and, thus, allowing for a narrower side power rail.

The first power rail and the second power rail can be a backside power rails.

In an embodiment, a contact area between the side power rail and the at least one contact structure is vertically aligned with a bottom side of the CFET element.

In an embodiment, a width of the side power rail is in a range from 10 nm to 30 nm. This width may refer to a width in a gate direction of the CFET structure.

For example, in case of a tapered shape, the side power rail has a width of less than 20 nm at its narrowest section. Furthermore, the side power rail can have a width of one or two tracks at its widest section (i.e., at the top), wherein the tracks may refer to signaling lines which are arranged above the second transistor structure. The signaling lines can be formed from a horizontal metal layer, e.g. a metal zero (Mo) layer.

For example, the side power rail and the at least one contact structure have roughly the same height (relative to a stacking direction of the CFET).

In an embodiment, the at least one contact structure comprises at least one via or a rail structure.

For instance, the side power rail and the second power rail extend along the same axis (e.g., the channel direction). The contact structure can comprise a number of vias which are arranged along the axis or a rail structure which extends along the axis.

In an embodiment, the first and the second power rail are arranged at different distances to the CFET element.

The first and the second power rail can be arranged at different vertical levels of the CFET structure. For instance, the second power rail is arranged below the first power rail. Thereby, the first power rail can be formed from a backside M0 layer (BSM0) and the second power rail can be formed from a backside M1 layer (BSM1).

In an embodiment, the first and the second power rail run parallel or perpendicular to each other.

In an embodiment, the CFET structure further comprises at least one backside contact structure, in particular at least one further via, which is arranged to electrically connect the first power rail to the first transistor structure from below.

For example, the first power rail can run directly below the first transistor structure.

In an embodiment, the first power rail is electrically connected to a source and/or drain structure of the first transistor structure; and the side power rail is electrically connected to a source and/or drain structure of the second transistor structure.

A second aspect of this disclosure provides a method of fabricating a complementary field effect transistor (CFET) structure. The method comprises: forming at least one CFET element, wherein the at least one CFET element comprises: a first transistor structure, and a second transistor structure which is arranged above the first transistor structure. The method further comprises: forming a first power rail arranged below the CFET element, wherein the first power rail is electrically connected to the first transistor structure from below; forming a side power rail arranged on one side of the CFET element, wherein the side power rail is electrically connected to the second transistor structure from the side; forming a second power rail arranged below the CFET element; and forming at least one contact structure which is arranged to electrically connect the second power rail with the side power rail.

Thereby, the order of the steps of the method is not fixed. Typically, the first and the second power rails are formed after the fabricating the side power rail and the at least one contact structure.

In an embodiment, the side power rail is formed by etching a channel in a substrate material on the side of the CFET element and filling the channel with a conductive material.

As a consequence of the etching process, e.g. an SiO₂ etching, the channel and thus the resulting side power rail can have a tapered shape.

In an embodiment, a width of the side power rail is in a range from 10 nm to 30 nm. For instance, the tapered side power rail has a width of at least 10 nm at its narrowest section and not more than 30 nm at its widest section.

In an embodiment, the at least one contact structure is first formed from a dummy material which is replaced by a conductive material in a subsequent step.

In an embodiment, the at least one contact structure is formed prior to the formation of the side power rail. For example, the at least one contact structure can be processed from the front side or from the back side of the CFET structure.

In an embodiment, the at least one contact structure comprises at least one via or a rail structure.

In an embodiment, the method further comprises: forming at least one backside contact structure, in particular at least one further via, which is arranged to electrically connect the first power rail to the first transistor structure from below.

In an embodiment, a contact area between the side power rail and the at least one contact structure is vertically aligned with a bottom side of the CFET element.

In an embodiment, the first and the second power rail run parallel or perpendicular to each other.

In an embodiment, the method comprises: electrically connecting the first power rail to a source and/or drain structure of the first transistor structure; and electrically connecting the side power rail to a source and/or drain structure of the second transistor structure.

The CFET structure according to the first aspect of this disclosure can be fabricated by the method according to the second aspect of this disclosure.

### BRIEF DESCRIPTION OF THE DRAWINGS

The above described aspects and implementations are explained in the following description of embodiments with respect to the enclosed drawings:
- FIG. 1: shows a schematic diagram of a CFET structure according to an embodiment;
- FIG. 2: shows a schematic diagram of first and second power rails of a CFET structure according to an embodiment;
- FIG. 3: shows a perspective view of a CFET structure according to an embodiment; and
- FIGS. 4A-O: show steps of a method of fabricating a CFET structure according to an embodiment.

### DETAILED DESCRIPTION OF EMBODIMENTS

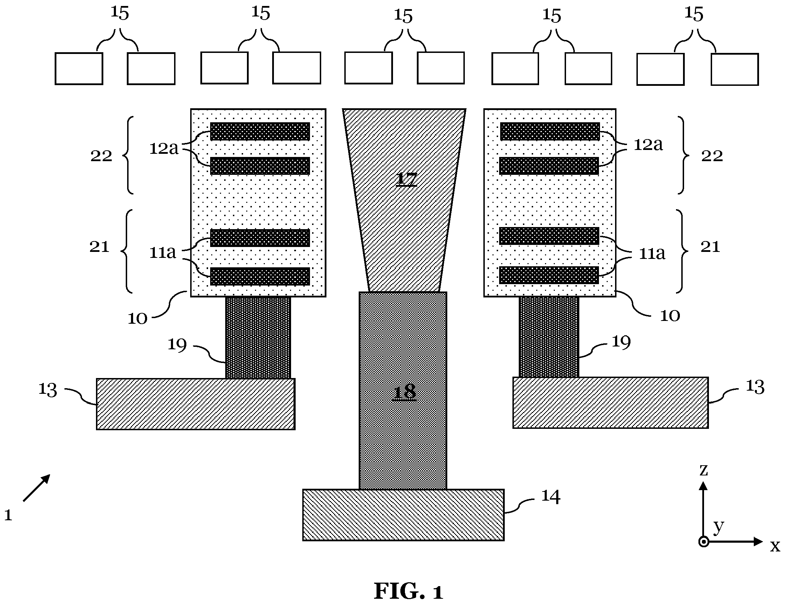

FIG. 1 shows a schematic diagram of a CFET structure 1 according to an embodiment. Thereby, FIG. 1 shows a cross-sectional view through an x-z plane (as indicated by the Cartesian coordinate system), which is perpendicular to a channel direction (y-direction) of the CFET structure 1.

The CFET structure comprises at least one CFET element 10, wherein the CFET element 10 comprises a first transistor structure 21 and a second transistor structure 22 which is arranged above the first transistor structure 21. The CFET structure 1 further comprises: a first power rail 13 arranged below the CFET element 10, wherein the first power rail is electrically connected to the first transistor structure 21 from below; a side power rail 17 arranged on one side of the CFET element 10, wherein the side power rail 17 is electrically connected to the second transistor structure 22 from the side; a second power rail 14 arranged below the CFET element 10; and at least one contact structure 18 which is arranged to electrically connect the second power rail 14 with the side power rail 17.

Hereby, the relative terms "above" and "below" (or "top" and "bottom") indicate a vertical arrangement along a z-direction, as indicated by the Cartesian coordinate system. This z-direction can be the "stacking direction" of the transistor structures and their elements. For instance, the first transistor structure 21 can be a bottom transistor structure and the second transistor structure 22 can be a top transistor structure of the respective CFET element 10.

In the example shown in FIG. 1, the CFET structure 1 comprises two CFET elements 10, wherein the side power rail 17 is arranged between both CFET elements. The side power rail 17 can be electrically connected to the second (top) transistor structure 22 of one or both of these CFET elements 10. In particular, the side power rail 17 can be a shared power rail of both CFET elements 10. In the design example of FIG 1, a respective first power rail 13 is arranged below each CFET element 10 and connected to the first transistor structure 21 of each CFET element 10 from below.

The at least one CFET element 10 (or more specifically its transistor structures 21, 22) can form a CFET cell. The CFET cell can be a base cell, in particular a double row base cell, of the CFET structure. For instance, the CFET cell is a logic cell or a component of a logic cell. The size of the CFET cell and, in particular, the number of its first and second (or bottom and top) transistor structures 21, 22 can depend on its function.

For example, the first (bottom) transistor structures 21 of the respective CFET elements 10 are arranged in a first tier or level of the CFET structure 1 and the second (top) transistor structures 22 of the respective CFET elements 10 are arranged in a second tier or level of the CFET structure 1, above the first tier.

The transistor structures 21, 22 may be NMOS and PMOS transistor structures. For instance, the first transistor structure 21 maybe an NMOS transistor structure and the second transistor structure 22 maybe a PMOS transistor structure, or vice versa.

The first power rail 13 may supply a VDD voltage and the second power rail may supply a VSS voltage 14. However, depending on which transistor structure is NMOS and PMOS this could also be reversed.

Each of the first and the second transistor structure 21, 22 can comprise a respective channel structure 11a, 12a, wherein each channel structure 11a, 12a can comprise a number of channel layers, which extend along a y-axis as indicated by the coordinate system. Furthermore, each of the first transistor structure 21 and the second transistor structure 22 can comprise at least two source and/or drain structures and a gate structure. The gate structure can be a common gate structure of a bottom and a top transistor structure 21, 22 of a CFET element 10.

As shown in FIG. 1, the first and the second power rails 13, 14 can be arranged at different distances to the CFET elements 10. For example, the first and the second power rails 13, 14 are arranged at different (vertical) levels of the CFET structure 1.

Arranging the power rails 13, 14 at different levels reduces space restrictions for these power rails 13, 14 and allows to make the individual rails 13, 14 wider. However, this comes at the expense of an increased vertical distance between the lower (second) power rail 14 and the side power rail 17. This disadvantage is overcome by the at least one contact structure 18, which allows to keep the side power rail 17 relatively short (in height) while establishing an electrical contact between the second power rail 14 and the side rail 17.

The first power rail 13 and the second power rail 14 can each be backside power rails. These rails can each have a height (in z-direction) of roughly 100 nm. For example, the vertical distance between the power rails 13 and 14 can be roughly 100 nm and the distance from the first (top) power rail 13 to the bottom side of the CFET element 10 can be in a range from 20 to 80 nm.

As an alternative to the arrangement shown in FIG. 1, the first and the second power rail 13, 14 could also be arranged at the same distance from the CFET element, e.g. at the same vertical level. This would have the advantage that the distance between the second power rail 14 and the side power rail 17 is reduced but would lead to size restrictions for the power rails.

As shown in FIG. 1, the side power rail 17 can be tapered towards the at least one contact structure 18. The tapering can be a consequence of an oxide etching step during side power rail 17 fabrication. For example, the tapering angle is ca. 87°.

This tapering puts a limitation on a maximum height (in z-direction) of the side power rail 17 and on a minimum width (in x-direction) at its widest section. For example, without the contact structure 14 this height/width limitation would make it difficult to efficiently contact a second VSS power rail 14, especially if this VSS power rail 14 which is arranged at a lower level than the first VDD power rail 13. The contact structure 18 bridges the distance between the side power rail 17 and the (lower) second power rail 14. In this way, an overly narrow tip of the tapered side power rail 17 can be avoided.

For example, the height of the side power rail 17 can be roughly equal to the height of the CFET element 10, such that a contact area between the side power rail 17 and the at least one contact structure 18 is vertically aligned with a bottom side of the CFET element(s) 10. The remaining distance between the side power rail and the second power rail 14 can be bridged by the at least one contact structure 18.

The width of the side power rail 17 (in x-direction according to the Cartesian coordinate system) maybe in a range from 10 nm to 30 nm. For instance, the width can be at least 10 nm at its narrowest section (where it contacts the contact structure 18) and not more than 30 nm at its widest section (at the top). The height of the side power rail 18 and/or of the CFET element 10 (in z-direction) can be in a range from 100 to 120 nm.

The side power rail 17 being constructed as a continuous rail which runs along the CFET element 10 (in y-direction) can reduce a power consumption along the power rails. However, instead of a continuous side power rail 17, the element 17 could in principle also be realized by a number of vias which are arranged along the CFET element 10. Such a design could reduce parasitic effects and loss in performance compared to a rail.

The at least one contact structure 18 can comprise at least one via or a rail structure. For instance, the side power rail 17 and the second power rail 14 extend along the same channel direction (y-axis in FIG. 1). The contact structure 18 can comprise a number of vias which are arranged along this direction or a rail structure which extends along this direction.

The CFET structure 1 can further comprise at least one backside contact structure 19 which is arranged to electrically connect the first power rail 13 to the first transistor structure 21 from below. In particular, the backside contact (BSC) structure 19 can directly connect a source (or drain) of the first (bottom) transistor structure 21 to the first power rail 13. For instance, the first power rail 13 runs directly below the first transistor structure 21 and the backside contact structure 19 comprises a number of electrical vias which are arranged along the channel direction (y-direction).

The CFET structure 1 can further comprise a set of signaling routing lines 15 (also referred to as metal tracks) which are arranged above the second transistor structure 22 of the CFET elements 10.

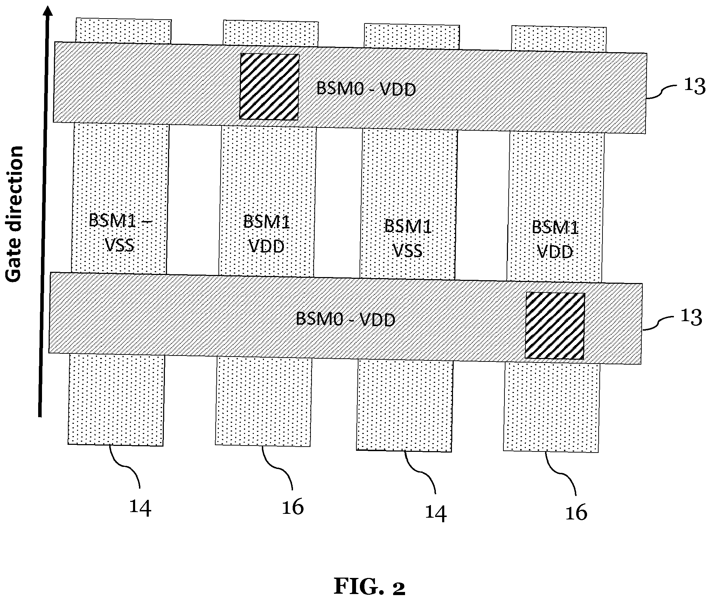

FIG. 2 shows a schematic diagram of the first and second power rails 13, 14 of the CFET structure 1 according to an embodiment. Thereby, FIG. 2 shows a top view, wherein the gate direction (x-direction according to the Cartesian coordinate system in FIG. 1) is indicated.

In the example, shown in FIG. 2, the first and the second power rails 13, 14 run perpendicular to each other, wherein the first power rail 13 is arranged above the second power rail 14 relative to a stacking direction (z-direction according to the Cartesian coordinate system in FIG. 1). The first power rail 13 can be formed from a backside M0 layer (BSM0) and the second power rail 14 can be formed from a backside M1 layer (BSM1). For instance, the first power rail 13 is a BSM0-VDD rail and the second power rail 14 is a BSM1-VSS rail.

For example, the BSM0-VDD rails 13 can be electrically connected to a further VDD rails 16 at the BSM1 level, as indicated by the dashed boxes, to receive VDD power. These power rails 13, 14, 16 can be a part of a backside power delivery network.

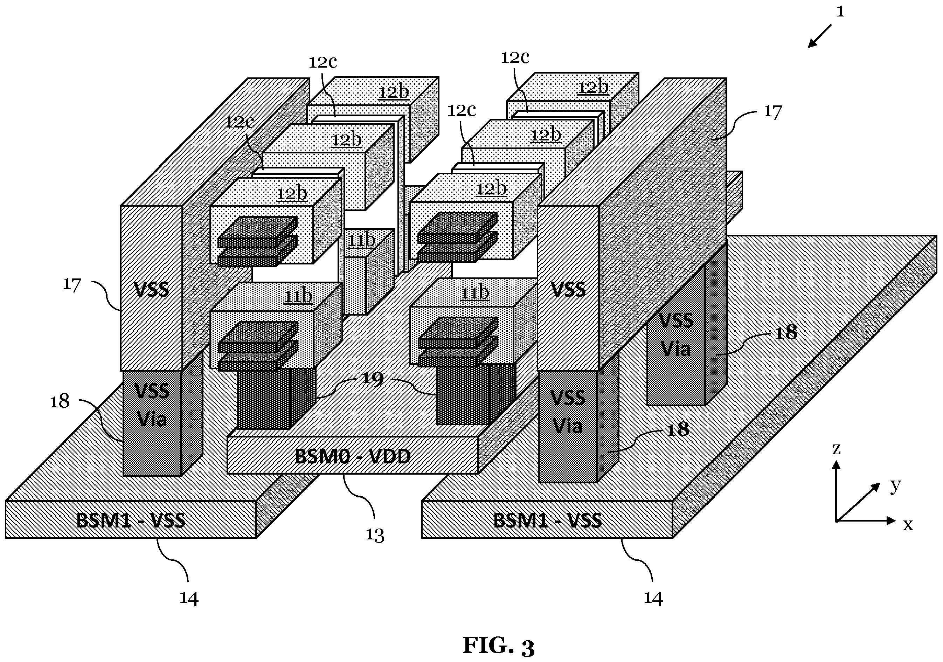

As an alternative to the arrangement in FIG. 2, the first and the second power rails 13, 14 could also be arranged to run parallel to each other, as shown in FIG. 3.

FIG. 3 shows a perspective view of the CFET structure 1 according to an embodiment. In the example shown in FIG. 3, the CFET structure 1 again comprises two CFET elements 10, wherein respective side power rails 17 are arranged on the sides of the CFET elements 10 which face away from each other.

FIG. 3 shows a number of source and/or drain structures 11b, 12b of the first and the second transistor structures 21, 22. These source and/or drain structures 11b, 12b are arranged along the channel layers.

For instance, the first power rail 13 can be electrically connected to at least one source and/or drain structure 11b of the first transistor structure 21 via the backside contact structures 19, and the side power rail 17 can be electrically connected to at least one source and/or drain structure 12b of the second transistor structure 22 from the side, e.g., via a horizontal contact structure (not visible in the schematic drawing of FIG. 3).

The first and the second transistor structures 21, 22 can further comprise a number of gate structures 12c, e.g. shared gate structures.

For example, both the backside contact structure 19 and the contact structure 18 can comprise electrical vias which are arranged along the first respectively second power rail 13, 14.

Arranging the second power rail 14 below the first power rail 13 and/or connecting the side power rail 17 to the second power rail 14 via the contact structure 18, as shown in FIG. 1 and 3, provides several advantages: (i) the side power rail 17 can be shorter in height, avoiding a very narrow tip that would occur when the side rail 17 would extend all the way to the (lower) second power rail 14; (ii) the overall resistance of the VSS power delivery network can be lower (in case the side power rail is a VSS rail); (iii) the side power rail 17 can be more scalable, allowing for a cell height scaling of the CFET structure 1; (iv) due to the height difference between the contact structure 18 and the backside contact structure 19, the contact structure 18 can be self-aligned to the layer of the second power rail 14 (e.g., BSM1); (iv) considering a rail cut of the side power rail 17, the contact structure 18 (e.g., a via) could be used to route signals from front to back.

Besides CFET structures, the above power supply scheme can be applicable to other FET architectures, such as FinFET, Nanosheet, or Forksheet.

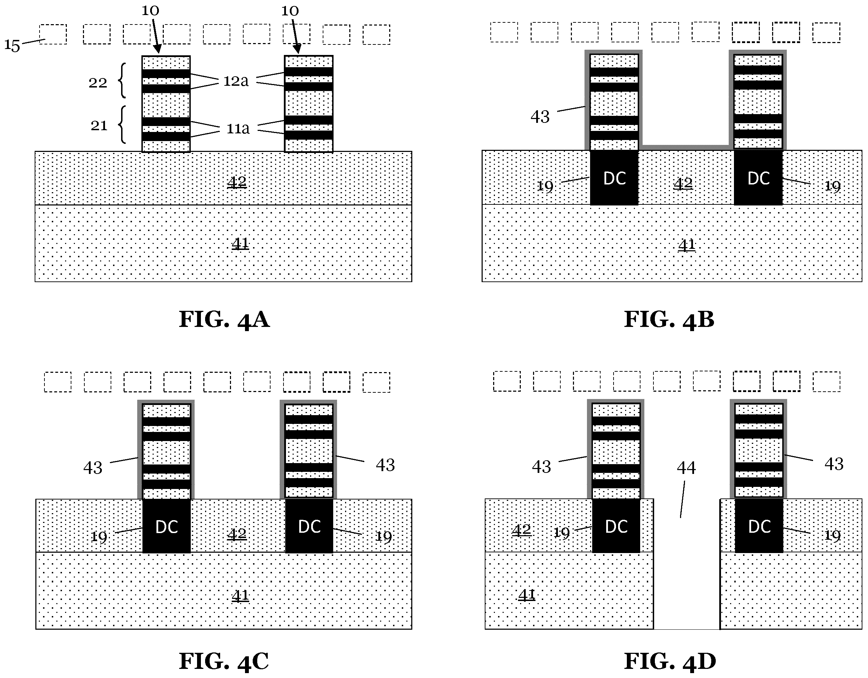

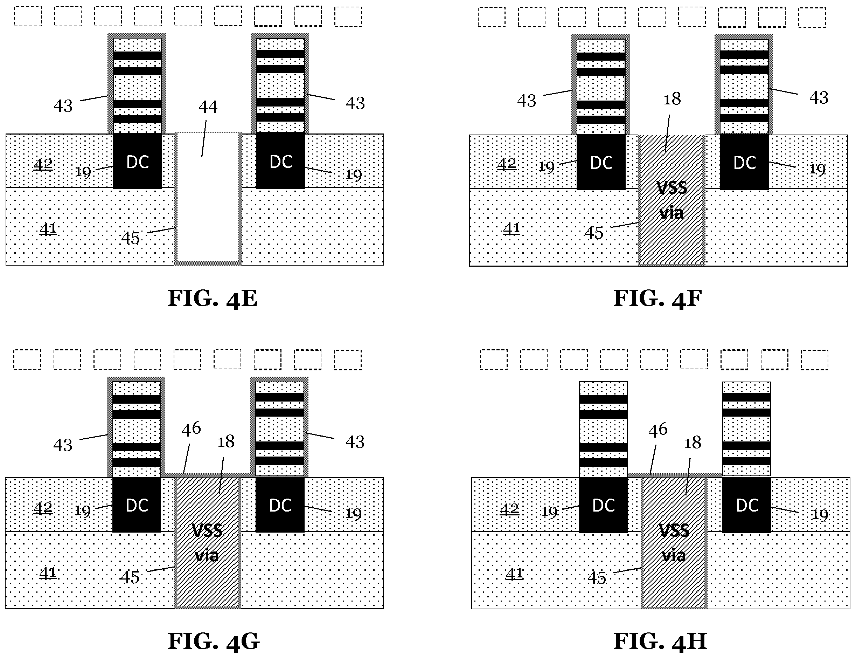

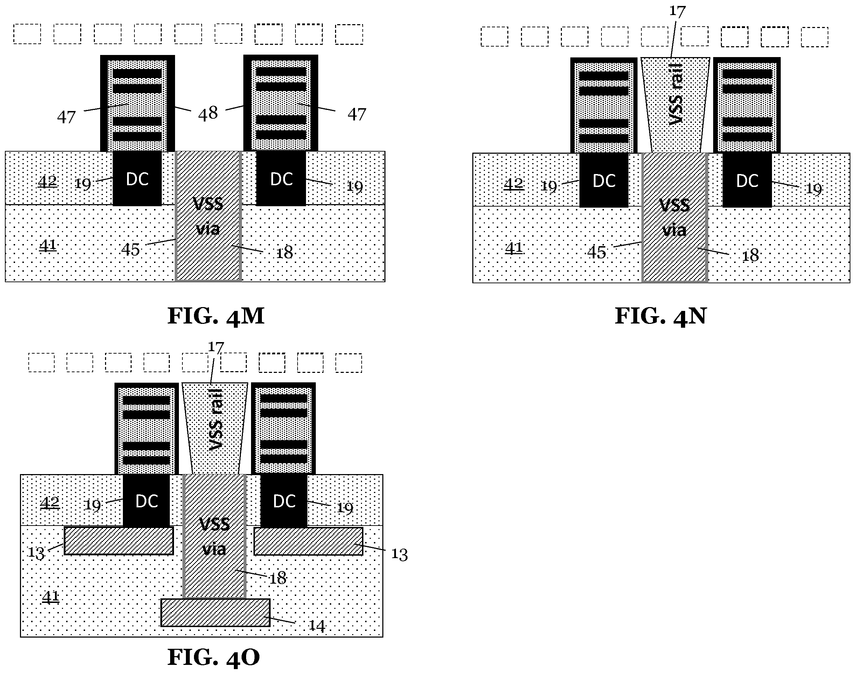

FIGS. 4A-O show steps of a method of fabricating a CFET structure 1 according to an embodiment. Thereby, the sequence of the fabrication steps as shown in FIGS. 4A-O and as discussed in the following is only an example. A different sequence for forming the various elements could be used, depending on the fabrication techniques. The general steps of this method could be used to fabricate any one of the CFET structures 1 as shown in FIGS. 1 or 3.

As shown in FIG. 4A, the method comprises the step of forming the at least one CFET element 10, wherein the CFET element 10 comprises the first transistor structure 21, and the second transistor structure 22 which is arranged above the first transistor structure 21.

In FIGS. 4A-O, a CFET structure 1 comprising two CFET elements 10 is fabricated. Thereby, signaling routing lines 15 above the CFET elements 10 are shown in all figures. This is only to provide a visual reference, as these structures 15 are typically fabricated in a later step not shown in FIGS. 4A-O.

The CFET elements 10 can be formed by patterning of a nanosheet structure which comprises the channel layers 11a, 12a of the first and the second transistor structure 21, 22. The source and/or drain structure and gate structures of the transistor structures 21, 22 can be formed in a later step.

The CFET elements 10 can be formed on a substrate 41, e.g. a silicon substrate, which is covered by an STI (shallow trench isolation) layer 42.

As shown in FIG. 4B, the method may comprise the further step of: forming at least one backside contact structure 19, in particular at least one further via. The backside contact structure 19 is arranged to electrically contact the first transistor structure 21 from below.

The backside contact structure(s) 19 can be formed from a metal or from a replacement material that is replaced by a metal in a later step. For example, the backside contact structure(s) 19 can be formed in the STI layer 42.

Furthermore, a liner 43 can be deposited around the CFET elements 10. The liner can be formed from a dielectric material.

In a subsequent step, shown in FIG. 4C, the liner 43 can be etched back in an area between the two CFET elements 10.

Subsequently, as shown in FIGS. 4D-4F, the contact structure 18 can be formed. Therefore, a number of holes or a trench 44 can be etched in the STI layer 42 and the substrate 41, at the area where the liner 43 was removed (FIG. 4D). The holes or the trench 44 can be lined with a further liner layer 45, e.g., to avoid diffusion into the silicon substrate 41 (FIG. 4E). Finally, the hole or trench 44 can be filled with a conductive material to form the contact structure 18. For instance, if the contact structure 18 is generated by etching and filling holes, it may comprise a number of vias, and if the contact structure 18 is generated by etching and filling a trench, it may be a rail structure.

In particular, for processing the contact structure 18, both the substrate 41 and the STI layer 42 are etched. The contact structure 18 can be self-aligned to a metal layer (e.g., BSM1) below the CFET elements 10 due to the height difference between the contact structure 18 and the backside contact structure 19.

As an alternative to directly filling the holes or the trench 44 with the conductive materials, it is also possible to fill these cavities 44 with a dummy material (also referred to as: sacrificial or replacement material) first, and to replace said dummy material with the conductive material in a later step.

In FIGS. 4D-4F the contact structure 18 is formed from the front side of the CFET structure 1. However, it is also possible to form this contact structure 18 from the backside of the CFET structure 1 instead.

Subsequently, a further liner layer 46 can be deposited on the contact structure 18, as shown in FIG. 4G. Then, the liner layer 43 can be removed around the CFET elements 10 (FIG. 4H).

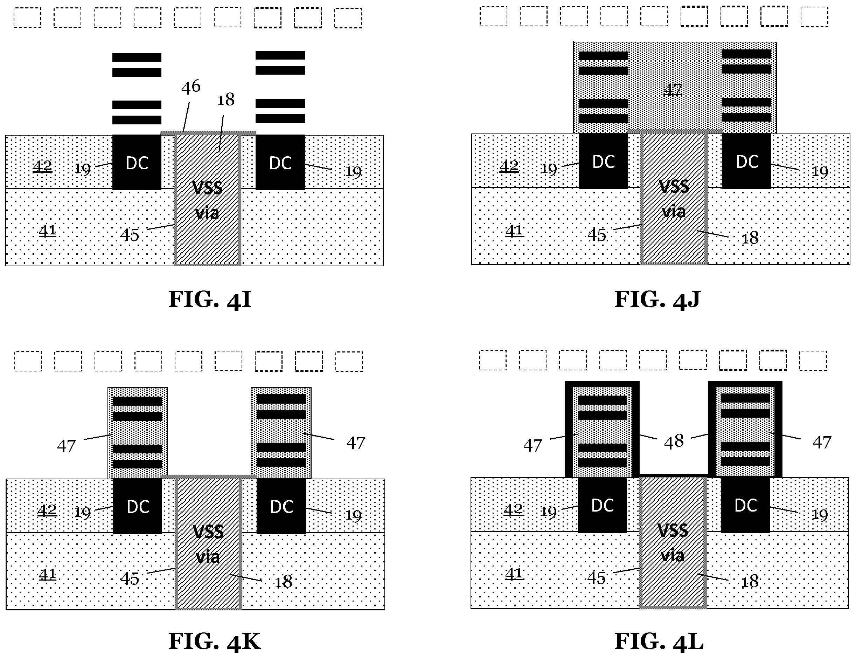

Then, as shown in FIGS. 4I-4K, a gate structure 12c of the first and second transistor structures 21, 22 of the CFET elements 10 can be formed. Therefore, material layers which separate the channel layers 11a, 12a of the CFET elements 10 can be released (FIG. 4I) and a gate material 47 can be deposited, wherein the gate material may wrap around the individual channel layers 11a, 12a and may fill the space between the adjacent CFET elements 10 (FIG. 4J). Subsequently, a gate cut can be carried out, to separate the gate structures of the individual CFET elements 10 (FIG. 4K).

For instance, the gate structure, which is formed in the steps shown in FIGS. 4I-4K, could be a replacement metal gate and the gate material 47 a replacement (or dummy) material.

In a subsequent step shown in FIG. 4L, a spacer layer 48 can be deposited around the gate material 47 and on the contact structure 18. This layer 48 can then be removed from the contact structure 18 by a spacer etch back step, as shown in FIG. 4M.

On top of the thus exposed contact structure 18, the side power rail 17 can be formed. This can be realized by etching a channel or trench in a substrate material which surrounds the CFET elements 10, e.g. an oxide layer, and filling said channel or trench with a conductive material. As a result of this oxide etching, the side power rail 17 can have a tapered shape. For instance, a width of the side power rail 17 is in a range between 10 nm to 30 nm.

The side power rail can be electrically connected to at least one second transistor structure 22 from the side, e.g. to a source and/or drain structure of the second transistor structure 22. This can be realized by a horizontal contact structure (not shown).

Subsequently, as shown in FIG. 4O, the first and the second power rails 13, 14 can be formed below the CFET elements 10. Thereby, the first power rail 13 is electrically connected to the first transistor structure 21 via the backside contact structure 19, and the second power rail 14 is electrically connected to the side power rail 17 via the contact structure 18.

The first and second power rails 13, 14 can be formed as backside metal layers using a backside processing technique.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A complementary field effect transistor, CFET, structure (1), comprising:
at least one CFET element (10) comprising:
- a first transistor structure (21), and
- a second transistor structure (22) which is arranged above the first transistor structure (21);
wherein the CFET structure (1) further comprises:
a first power rail (13) arranged below the CFET element (10), wherein the first power rail (13) is electrically connected to the first transistor structure (21) from below;
a side power rail (17) arranged on one side of the CFET element (10), wherein the side power rail (17) is electrically connected to the second transistor structure (22) from the side;
a second power rail (14) arranged below the CFET element (10); and
at least one contact structure (18) which is arranged to electrically connect the second power rail (14) with the side power rail (17).

2. The CFET structure (1) of claim 1,
wherein a contact area between the side power rail (17) and the at least one contact structure (18) is vertically aligned with a bottom side of the CFET element (10).

3. The CFET structure (1) of claim 1 or 2,
wherein a width of the side power rail (17) is in a range from 10 nm to 30 nm.

4. The CFET structure (1) of any one of the preceding claims,
wherein the at least one contact structure (18) comprises at least one via or a rail structure.

5. The CFET structure (1) of any one of the preceding claims,
wherein the first and the second power rail (14) are arranged at different distances to the CFET element (10).

6. The CFET structure (1) of any one of the preceding claims,
wherein the first and the second power rail (14) run parallel or perpendicular to each other.

7. The CFET structure (1) of any one of the preceding claims, further comprising:
at least one backside contact structure (19), in particular at least one further via, which is arranged to electrically connect the first power rail (13) to the first transistor structure (21) from below.

8. The CFET structure (1) of any one of the preceding claims,
wherein the first power rail (13) is electrically connected to a source and/or drain structure (11b) of the first transistor structure (21); and
wherein the side power rail (17) is electrically connected to a source and/or drain structure (12b) of the second transistor structure (22).

9. A method of fabricating a complementary field effect transistor, CFET, structure (1), comprising:
forming at least one CFET element (10) comprising:
- a first transistor structure (21), and
- a second transistor structure (22) which is arranged above the first transistor structure (21);
forming a first power rail (13) arranged below the CFET element (10), wherein the first power rail (13) is electrically connected to the first transistor structure (21) from below;
forming a side power rail (17) arranged on one side of the CFET element (10), wherein the side power rail (17) is electrically connected to the second transistor structure (22) from the side;
forming a second power rail (14) arranged below the CFET element (10); and
forming at least one contact structure (18) which is arranged to electrically connect the second power rail (14) with the side power rail (17).

10. The method of claim 9,
wherein the side power rail (17) is formed by etching a channel in a substrate material on the side of the CFET element (10) and filling the channel with a conductive material.

11. The method of claim 9 or 10,
wherein a width of the side power rail (17) is in a range from 10 nm to 30 nm.

12. The method of any one of claims 9 to 11,
wherein the at least one contact structure (18) is first formed from a dummy material which is replaced by a conductive material in a subsequent step.

13. The method of any one of claims 9 to 12,
wherein the at least one contact structure (18) is formed prior to the formation of the side power rail (17).

14. The method of any one of claims 9 to 13,
wherein the at least one contact structure (18) comprises at least one via or a rail structure.

15. The method of any one of claims 9 to 14,
forming at least one backside contact structure (19), in particular at least one further via, which is arranged to electrically connect the first power rail (13) to the first transistor structure (21) from below.
